(19) Europäisches Patentamt
European Patent Office
Office européen des brevets

(11) Veröffentlichungsnummer: **0 075 710**
**B1**

# (12) EUROPÄISCHE PATENTSCHRIFT

(45) Veröffentlichungstag der Patentschrift: **13.11.85**

(51) Int. Cl.⁴: **G 01 R 31/28**, H 01 J 37/28

(21) Anmeldenummer: **82107491.1**

(22) Anmeldetag: **17.08.82**

(54) **Abtastverfahren zur Potentialbestimmung in der Elektronenstrahl-Messtechnik.**

(30) Priorität: **30.09.81 DE 3138992**

(43) Veröffentlichungstag der Anmeldung: **06.04.83 Patentblatt 83/14**

(45) Bekanntmachung des Hinweises auf die Patenterteilung: **13.11.85 Patentblatt 85/46**

(84) Benannte Vertragsstaaten: **DE FR GB NL**

(56) Entgegenhaltungen:
**DE - B - 1 943 140**
**GB - A - 1 187 901**

**IEEE JOURNAL SOLID-STATE CIRCUITS, Band SC-13, Nr. 3, Juni 1978 H.P. FEUERBAUM et al. "Quantitative measurement with high time resolution of internal waveforms on MOS RAM's using a modified scanning electron miscroscope" Seiten 319 bis 325**

(73) Patentinhaber: **Siemens Aktiengesellschaft, Berlin und München Wittelsbacherplatz 2, D-8000 München 2 (DE)**

(72) Erfinder: **Frosien, Jürgen, Dr., An der Ottosäule 18, D-8012 Ottobrunn (DE)**
Erfinder: **Lischke, Burkhard, Prof., In der Heulus 13, D-8000 München 82 (DE)**

EP 0 075 710 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

**Beschreibung**

Die Erfindung betrifft ein Abtastverfahren zur Potentialbestimmung in der Elektronenstrahl-Meßtechnik nach dem Oberbegriff des Anspruchs 1.

Die Messung der Signalverläufe im Inneren integrierter Schaltungen wird mit zunehmendem Integrationsgrad immer schwieriger. Mit Hilfe einer Elektronensonde können elektrische Potentiale an der Oberfläche integrierter Schaltungen abgebildet werden. Die meisten integrierten Schaltungen müssen dynamisch geprüft werden, d. h. sie müssen während der Untersuchung mit Nennfrequenz arbeiten.

Für die Potentialmessung zeitlich periodischer Vorgänge mit Hilfe der Elektronenstrahl-Meßtechnik ist es bekannt, daß unter Ausnutzung des Stroboskopie-Effektes solche Schaltkreise, die während der Untersuchung mit Nennfrequenz arbeiten, quasistatisch im Potentialkontrast abgebildet werden. Dabei wird ein gepulster Elektronenstrahl verwendet, der synchron mit der Schaltungsfrequenz zu einem festen Zeitpunkt $t_1$ das Schaltungspotential an einem bestimmten Meßpunkt abfragt. Um eine hohe Zeitauflösung zu erhalten, ist die Pulsbreite $\Delta t$ dabei klein gegen die Periodendauer des Schaltungssignals (stroboskopische Beleuchtung). Nach dem Prinzip des Sampling-Oszillographen wird aus dem periodischen Meßsignal ein Phasenpunkt ausgewählt (Einschaltzeitpunkt des Elektronenstrahls) und mit einer Sekundärelektronen-Spektrometeranordnung der Spannungswert dieses Phasenpunktes bestimmt. Durch langsames Verschieben des Einschaltzeitpunktes (Phase) wird das zu messende Signal als Funktion des Phasenwinkels abgetastet (H. P. Feuerbaum et al., Quantitative Measurement with high time resolution of internal waveforms on MOS-RAM s using a modified scanning electron microscope, IEEE J. SC, Vol. SC-13, No. 3, Juni 1978, S. 319—325). Nachteil dieses bekannten Verfahrens ist, daß wegen der kurzen Pulsdauer der Elektronensonde nur ein kleiner Bruchteil des Stromes in der Elektronensonde zur Potentialmessung genutzt werden kann, da der Primärelektronenstrahl zum größten Teil der Zeit dunkel getastet ist. Dadurch entstehen lange Meßzeiten.

Der Erfindung liegt die Aufgabe zugrunde, ein Abtastverfahren zur Potentialbestimmung in der Elektronenstrahl-Meßtechnik der eingangs genannten Art anzugeben, welches es ermöglicht, die Geschwindigkeit bei der Elektronenstrahlpotentialmessung deutlich zu erhöhen.

Diese Aufgabe wird erfindungsgemäß durch ein Abtastverfahren der eingangs genannten Art gelöst, welches die kennzeichnenden Merkmale des Anspruchs 1 aufweist.

Ausgestaltungen und Vorteile der Erfindung sind in den abhängigen Ansprüchen, der Beschreibung und der Zeichnung dargestellt.

Die Erfindung wird in der Zeichnung näher erläutert.

Fig. 1 zeigt das Prinzip eines konventionellen Verfahrens zum Abtasten eines periodischen Signalverlaufes mit Hilfe eines gepulsten Elektronenstrahles.

Fig. 2 zeigt das Prinzip eines erfindungsgemäßen Verfahrens zum Abtasten des periodischen Signalverlaufes zur Verkürzung der Meßzeit.

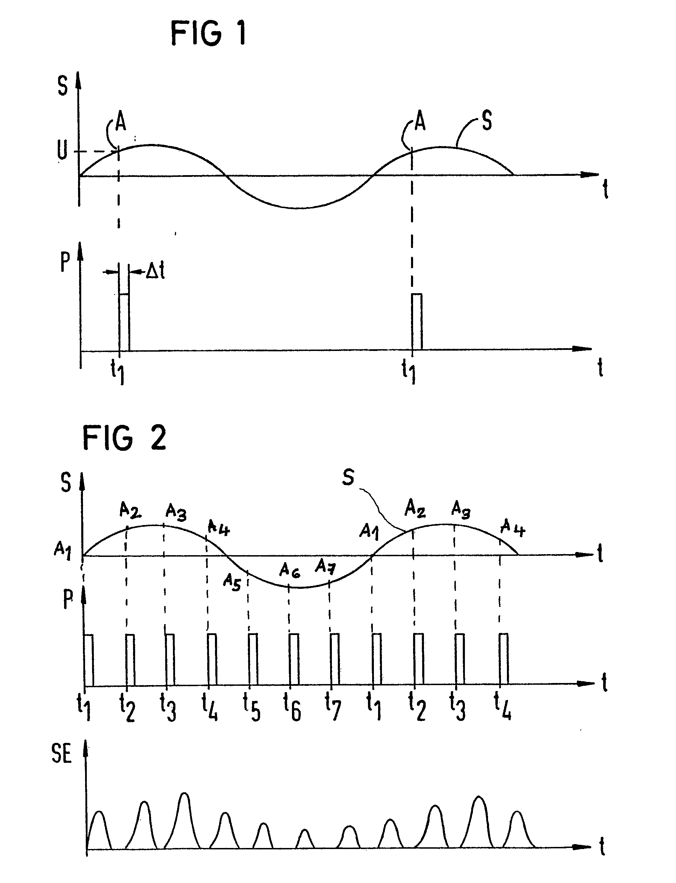

Fig. 1 zeigt das Prinzip eines konventionellen Verfahrens zum Abtasten eines periodischen Signalverlaufes S mit Hilfe eines gepulsten Elektronenstrahls P. Der periodische Signalverlauf S und der gepulste Elektronenstrahl P sind gegen die Zeit t aufgetragen. Die mit einem Elektronenstrahl-Meßgerät zu vermessende Schaltung wird zyklisch betrieben und der Elektronenstrahl wird gepulst. Nach dem Prinzip des Sampling-Oszillographen wird aus dem periodischen Signalverlauf S ein Phasenpunkt A als Einschaltzeitpunkt $t_1$ des gepulsten Elektronenstrahls P ausgewählt. Mit der Sekundärelektronen-Spektrometeranordnung des Elektronenstrahlmeßgerätes wird der Spannungswert U dieses Phasenpunktes A bestimmt. Um eine hohe Zeitauflösung zu erhalten, ist die Pulsbreite $\Delta t$ klein gegen die Periodendauer des periodischen Signales. Durch langsames Verschieben des Einschaltzeitpunktes (Phase) wird der zu messende periodische Signalverlauf S als Funktion des Phasenwinkels abgetastet. Das Meßergebnis kann entweder am Oszillographen oder x—y-Schreiber aufgezeichnet werden. Wie aus der Fig. 1 leicht zu ersehen ist, kann wegen der kurzen Pulsdauer des gepulsten Elektronenstrahls P nur ein kleiner Bruchteil des Primärelektronenstromes in der Elektronensonde zur Messung des periodischen Signalverlaufes S genutzt werden. Wie in Fig. 1 deutlich dargestellt ist, ist der Primärelektronenstrahl P des Elektronenstrahl-Meßgeräts zum größten Teil der Zeit dunkel getastet. Dadurch entstehen lange Meßzeiten.

Fig. 2 zeigt das Prinzip eines erfindungsgemäßen Verfahrens zum Abtasten des periodischen Signalverlaufs S zur Verkürzung der Meßzeit. Zur Steigerung der Meßgeschwindigkeit wird der periodische Signalverlauf S am zu vermessenden Meßpunkt einer Schaltung während einer Periode des periodischen Signalverlaufes S nicht nur einmal, sondern mehrmals zu den Zeiten $t_1$, $t_2$ ... $t_n$ abgefragt. Insbesondere ist dabei der zeitliche Abstand zwischen zwei aufeinanderfolgenden Abtastzeitpunkten konstant also $t_{m+1} - t_m =$ konstant. In Fig. 2 wird der periodische Signalverlauf S während einer einzigen Periode siebenmal abgetastet, und zwar zu den Zeitpunkten $t_1$, $t_2$ ... $t_7$. Die dabei anfallenden Teilsignale werden zwischengespeichert. Der Minimalabstand zweier aufeinanderfolgender Pulse im gepulsten Elektronenstrahl P wird durch das Zeitverhalten des Sekundärelektronen-Signals SE bestimmt. Vor dem Start eines neuen Primärelektronenstrahlpulses des gepulsten Elektronenstrahles P muß nämlich das Sekundärelektronen-Signal SE des vorhergehenden Primärelektronenstrahlpulses abgeklungen sein. Entsprechend dem beim Stand der Technik genannten Abtastverfahren kann wiederum durch eine Phasenverschiebung zwischen der Pulsfolge des gepulsten Elektronenstrahls P und dem periodischen Signalverlauf S des Schaltungssignals der zeitliche Spannungsverlauf am Meßpunkt der Schaltung als Funktion der Zeit t gemessen werden. Bei einem erfindungsgemäßen Verfahren zum Abtasten des periodischen Signalverlaufs S braucht die Phase der Einschaltzeitpunkte $t_1, t_2 \ldots t_n$ nicht über die gesamte Periode des periodischen Signalverlaufs S geschoben zu werden. Wenn insbesondere die zeitlichen Abstände zwischen je zwei aufeinanderfolgenden Pulsen der Pulsfolge des gepulsten Elektronenstrahls P konstant ist, so muß die Phase des Einschaltzeitpunktes eines jeden Pulses der Pulsfolge des gepulsten Elektronenstrahls P nur über einen Bereich von:

$$\left(\frac{\text{Bereich, über welchem beim Stand der Technik die Phase geschoben werden muß}}{\text{Zahl der Pulse pro Periode des periodischen Signalverlaufs S}}\right)$$

geschoben werden. Da nun der periodische Signalverlauf S bei einem erfindungsgemäßen Abtastverfahren stückweise gemessen wird, müssen die einzelnen Teilsignale, die während des Abtastens des periodischen Signalverlaufs S getrennt zwischengespeichert worden sind, nach Vermessen des gesamten periodischen Signalverlaufs S durch Verschieben der Phase der Einschaltzeitpunkte der Pulse der Pulsfolge des gepulsten Elektronenstrahls P in der richtigen Reihenfolge ausgelesen werden, so daß der komplette periodische Signalverlauf S entsteht.

Durch ein erfindungsgemäßes Verfahren kann die Meßzeit gegenüber dem genannten Stand der Technik um ein Vielfaches, nämlich um

$$\frac{1}{\text{Zahl der Pulse des gepulsten Elektronenstrahls P pro Periode des periodischen Signalverlaufs S}}$$

reduziert werden.

Ein erfindungsgemäßes Verfahren läßt sich z. B. mit einem leicht modifizierten Elektronenstrahlmeßgerät entsprechend dem aus der genannten Veröffentlichung bekannten Elektronenstrahl-Meßgerät realisieren.

**Patentansprüche**

1. Abtastverfahren zur Potentialbestimmung in der Elektronenstrahl-Meßtechnik, wobei an einem Meßpunkt der zeitliche Signalverlauf (S) eines periodischen Signals bestimmt werden soll und hierfür eine Phasenverschiebung zwischen der Pulsfolge des gepulsten Elektronenstrahls (P) und dem periodischen Signalverlauf (S) des periodischen Signals ausgenutzt wird, dadurch gekennzeichnet, daß während einer Periode des periodischen Signalverlaufs (S) dieser periodische Signalverlauf (S) mehrmals, nämlich zu den Zeiten $t_1, t_2 \ldots t_n$, vom gepulsten Elektronenstrahl (P) abgetastet wird und die Phase der genannten Einschaltzeitpunkte hierfür zumindest über einen Teil der Periode des periodischen Signalverlaufs geschoben wird.

2. Abtastverfahren nach Anspruch 1, dadurch gekennzeichnet, daß zwei aufeinanderfolgende Pulse des gepulsten Elektronenstrahls (P) in jeweils konstantem zeitlichen Abstand aufeinanderfolgen, und daß die Phase der Einschaltzeitpunkte der Pulse des Elektronenstrahls (P) über einen Bereich geschoben wird, der der Periode des periodischen Signalverlaufs (S), geteilt durch die Zahl der auf eine solche Periode entfallenden Pulse des Elektronenstrahls, entspricht.

3. Abtastverfahren nach Anspruch 1 oder 2, dadurch gekennzeichnet, daß durch eine Phasenverschiebung zwischen dem gepulsten Elektronenstrahl (P) und dem periodischen Signalverlauf (S) der gesamte periodische Signalverlauf (S) als Funktion der Zeit (t) gemessen wird.

4. Abtastverfahren nach Anspruch 1 bis 3, dadurch gekennzeichnet, daß die Teilsignale von verschiedenen Phasen zwischen dem gepulsten Elektronenstrahl (P) und dem periodischen Signalverlauf (S) zwischengespeichert werden.

**Claims**

1. A scanning method for the determination of a potential in electron beam measuring techniques, wherein the timing signal pattern (S) of a periodic signal is to be determined at a measuring point and for this purpose a phase shift between the pulse train of the pulsed electron beam (P) and the periodic signal pattern (S) of the periodic signal is utilized, characterised in that during a period of the periodic signal pattern (S) the periodic signal pattern (S) is repeatedly scanned by the pulsed electron beam (P), namely at the times $t_1, t_2 \ldots t_n$, and the phase of said switch-on times is shifted over at least a part of the period of the periodic signal pattern.

2. A scanning method as claimed in Claim 1, characterised in that two consecutive pulses of the pulsed electron beam (P) are consecutive at a constant time distance and that the phase of the switch-on times of the pulses of the electron beam (P) is shifted over a region which corresponds to the period of the periodic signal pattern (S) divided by the number of pulses of the electron beam assigned to such a period.

3. A scanning method as claimed in Claim 1 or 2, characterised in that the entire periodic signal patter (S) is measured as a function of time (t) by means of phase displacement of the pulsed electron beam (P) and the periodic signal pattern (S).

4. A scanning method as claimed in Claims 1 to 3, characterised in that the sub-signals of various phases between the pulsed elektron beam (P) and the periodic signal pattern (S) are intermediately stored.

**Revendications**

1. Procédé d'exploration pour déterminer le potentiel conformément à la technique de mesure utilisant un faisceau électronique, la variation dans le temps (S) d'un signal périodique devant être déterminée au niveau d'un point de mesure, et un déphasage entre la suite des impulsions du faisceau électronique pulsé (P) et la variation périodique (S) du signal périodique étant utilisé à cet effet, caractérisé par le fait que pendant une période de la variation périodique (S) de ce signal périodique, l'exploration est effectuée par le faisceau électronique pulsé (P) à plusieurs reprises, à savoir aux instants ($t_1, t_2 \ldots t_n$), et la phase des instants indiqués de branchement est décalée à cet effet au moins sur une partie de la période de la variation périodique du signal.

2. Procédé d'exploration suivant la revendication 1, caractérisé par le fait que deux impulsions successives du faisceau électronique pulsé (P) se succèdent à un intervalle de temps constant et que la phase des instants de branchement des impulsions du faisceau électronique (P) est décalée sur une zone qui correspond à la période de la variation périodique (S) du signal, divisée par le nombre des impulsions du faisceau électronique, arrivant pendant une telle période.

3. Procédé d'exploration selon la revendication 1 ou 2, caractérisé par le fait que par un déphasage entre le rayon électronique pulsé (P) et l'allure périodique du signal (S) on mesure, en tant que fonction du temps, l'allure périodique totale du signal (S).

4. Procédé d'exploration selon la revendications 1 à 3, caractérisé par le fait que les signaux partiels de phases différentes entre le faisceau électronique pulsé (P) et l'allure périodique du signal (S) sont mémorisés temporairement.

FIG 1

S
A
U
A
S
t
P
Δt
t1
t1
t

FIG 2

S
S
A1
A2
A3
A4
A5
A6
A7
A1
A2
A3
A4
t
P
t1
t2
t3
t4
t5
t6
t7
t1
t2
t3
t4
t

SE
t